Europäisches Patentamt

**European Patent Office**

Office européen des brevets

(11) Publication number: **0 076 657**
**A2**

(12) # EUROPEAN PATENT APPLICATION

(21) Application number: **82305226.1**

(22) Date of filing: **30.09.82**

(51) Int. Cl.³: **H 05 K 5/00**
**H 01 R 13/514**

(30) Priority: **03.10.81 GB 8129944**

(43) Date of publication of application:
**13.04.83 Bulletin 83/15**

(84) Designated Contracting States:
**AT BE CH DE FR GB IT LI LU NL SE**

(71) Applicant: **BOOTHROYD STUART LIMITED**
**13 Clifton Road**
**Huntingdon Cambridgeshire PE18 7EJ(GB)**

(72) Inventor: **Boothroyd, Allen John**
**13 Clifton Road**
**Huntingdon Cambridgeshire PE18 7EJ(GB)**

(72) Inventor: **Stuart, John Robert**
**13 Clifton Road**
**Huntingdon Cambridgeshire PE18 7EJ(GB)**

(74) Representative: **Maguire, Peter Albert et al,**
**Fitzpatricks Kern House 61/62 Lincoln's Inn Fields**
**London WC2B 6EX(GB)**

(54) Housing for electrical apparatus.

(57) Electrical apparatus comprising a modular housing having a pair of opposite faces adapted to engage the corresponding faces of further similar modular housings of electronic apparatus, the modular housing having at least one series of bus bars extending between the opposite faces of the housing and arranged for direct electrical connection to the corresponding bus bars of the adjacent modular housings.

FIG.1

0076657

TITLE: ELECTRICAL APPARATUS

DESCRIPTION

The invention relates to electrical apparatus and more particularly, but not exclusively, to electronic audio and audio-visual apparatus of the general nature of amplifiers, pre-amplifiers, power supplies, filters, equalisers, radio tuners and television tuners. It is thought that the invention may also be applicable to electronic apparatus of the nature of computers and calculators.

It is conventional to interconnect different pieces of audio and audio-visual apparatus by means of cables but the large number of cables which are often required are at best unsightly or difficult to hide from view and in many cases the source of obscure faults in the operation of the apparatus or cause signal degradation.

Over the last few years there has been a trend towards modular construction techniques in the design of electronic apparatus so that servicing and circuit changes can be more readily accomplished. It is a fact however that the flexibility afforded by such systems is still limited by the original design of the mother board into which the modules are fitted.

It is an object of the invention to provide a modular construction system for electronic apparatus which overcomes or at least mitigates against the above stated problems.

According to the invention there is provided electrical apparatus comprising a modular housing having a pair of opposite faces adapted to engage further similar modular housings, the modular housing having at least one bus bar extending between the opposite faces and arranged for connection to the corresponding bus bars of adjacent modular housings whereby the modular housings can be electrically interconnected.

Preferably at least one series of bus bars extends between the opposite faces of the housing, each of which is arranged for direct electrical connection to the corresponding bus bars of the adjacent modular housings. Preferably one end of each bus bar is terminated by a pin connector and the other end of each bus bar is terminated by a socket connector.

Advantageously the apparatus comprises means for mechanically connecting the modular housings together independently of the bus bars. The means for mechanically connecting the modular housings together may comprise one or more (preferably a pair) of tie rods extending between the said opposite faces of the housing, the tie rods being arranged for connection to the corresponding tie rod of adjacent modular housings.

In a preferred arrangement said modular housing is generally rectangular in shape and comprises a front face which carries any necessary switches and visual indicators, a pair of side faces which form the said opposite faces and a rear face which carries any appropriate signal source inputs, power outputs and power outlets, the arrangement being such that the top of the modular housing projects over the rear face to shield the inputs and outputs.

If desired a flap may be hinged to the front face of the housing and arranged to cover at least one control on the front face. Preferably the hinged flap covers substantially the whole of the front face of the housing and is arranged to actuate a switch which energises the electrical circuitry associated with the modular housing.

For aesthetic reasons the depth and height of all the modules is preferably the same but the width of the modules may be varied as required by its contents. In this preferred arrangement each module, whether it is of the signal conditioning, signal processing or output kind, is complete in the sense that it carries all of the input connections, signal boosting circuitry and control means for that particular signal. It is usual with audio apparatus to feed a power amplifier from several sources, and it is envisaged that input or signal conditioning modules such as a magnetic tape module, a radio tuner module and a module for conditioning the output from a record pick-up cartridge each provided with its own inputs on the rear face and with its own controls on the front face, will be coupled together side by side, and electronically connected as appropriate by bus bars extending through the input modules to the power amplifier module or modules. In the same way one or more tone control or the like signal processing modules could be provided if desired side by side with the input and output modules and connected to the other modules by the bus bars. Preferably the pin and socket connections on the modules are arranged such that it is not possible to connect the modules together in an inappropriate sequence. It would be possible to provide a bridge piece which is coupled to one end of the series of modules by pin and socket connections and which serves the function of electrically connecting as appropriate the various bus bars, but we prefer to accomplish the connections electronically.

The bus bars may be arranged in two or more spaced series in each module, for example, low level signals can be carried by one series of bus bars while high voltage signals are carried by a further set of bus bars, but alternatively the bus bars may be arranged in a single row.

To permit one or more modules to be stacked above another module or series of modules we envisage a short flexible bus bar connector arranged to be connected to the bus bars of the upper and lower modules.

A preferred embodiment of the invention is diagrammatically illustrated by way of example in the accompanying drawings in which:-

Figure 1 is a partly exploded perspective view of a series of modular housings for electronic apparatus in accordance with the invention;

Figure 2 is a perspective view of the apparatus of Figure 1 taken from a different angle;

Figure 3 is a front view of a connector block for the electrical bus bars of the modules of Figures 1 and 2;

Figure 4 is a cross-sectional side view taken on the line A-A of Figure 3; and

Figure 5 is a cross-sectional view of a cap for protecting the connector pins of the electrical bus bars.

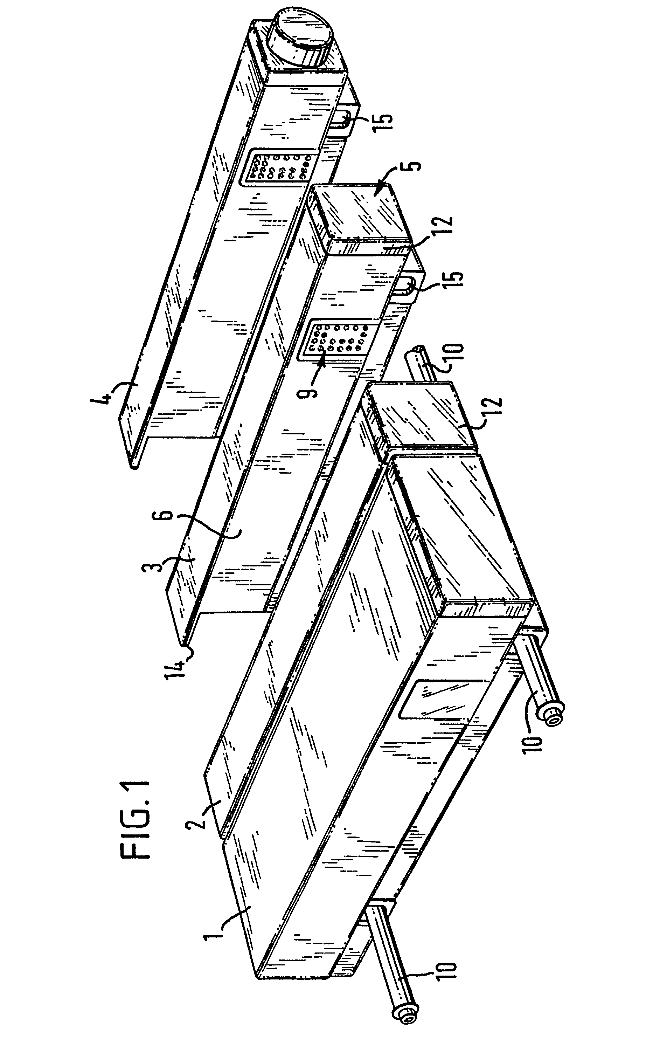

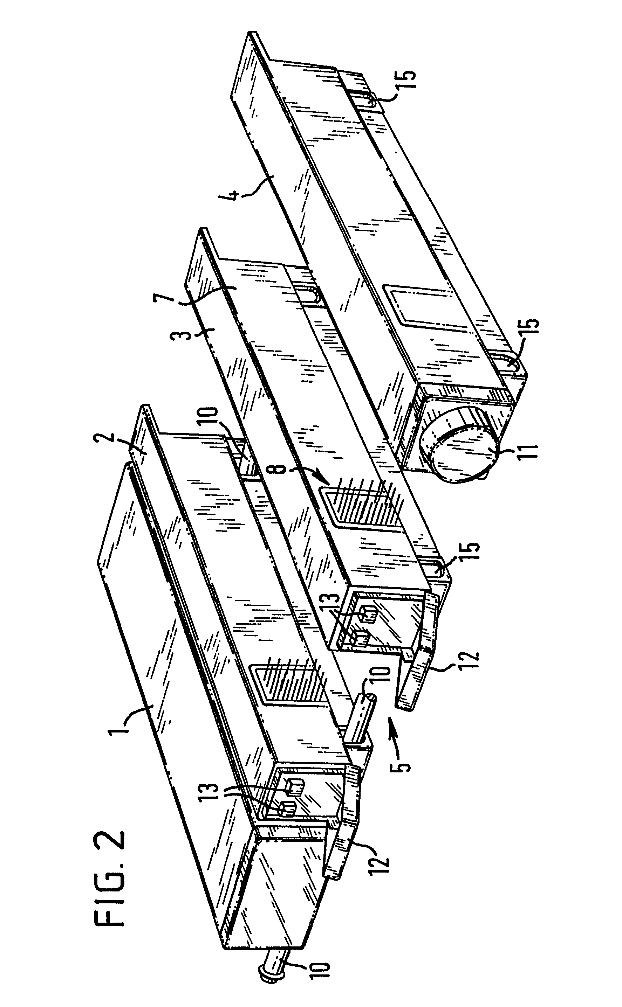

In the drawings there is shown a modular housing system for electrical apparatus by means of which the housings of various pieces of apparatus for example audio or audio-visual apparatus may be connected together directly without the need for interconnecting cables. Figures 1 and 2 show four such modules referenced 1 to 4 respectively. Thus module 1 is a power supply; module 2 is a switchable tone control; module 3 is a moving coil input and module 4 is a volume control, all for audio apparatus. Each module is generally rectangular in shape and comprises a front face formed with controls for actuating that module, a rear face which carries as appropriate input connections from associated equipment such as a record deck or tape recorder, or power inputs or power outputs and a pair of side faces arranged to engage the side faces of the adjacent modules. Thus for example the front face of module 3 is indicated by reference numeral 5 and its side faces are indicated by reference numerals 6 and 7 respectively. The modules each have a plurality of bus bars extending therethrough by means of which the modules are electrically interconnected and the bus bars are terminated at one end by pins 8 extending from the side face 7 of the module 3 and at the other end by sockets 9 on the other side 6 of the module 3. The modules 1, 2 and 4 are similarly provided with bus bars extending therethrough which are terminated on one side with pins and on the other side with sockets. In this manner the modules can be connected together directly side by side. The modules are also interconnected mechanically by means of a pair of tie rods 10 so that the modules are firmly interconnected independently of the pin and socket connectors. The tie bars 10 extend through apertures 15 in the respective modules.

As shown in Figures 1 and 2 the pre-amplifier module 4 is formed on its front face with a rotary volume control knob 11. It will be seen that the modules 2 and 3 have hinged flaps 12 which in their closed position cover the front faces of the respective modules, which flaps are arranged to actuate switches when in the closed position shown in Fig. 1 and when touched by means of which the electrical circuitry of the respective modules are brought into operation. When the hinged covers 12 are pivoted into the substantially horizontal position shown in Figure 2 they expose secondary controls for the circuitry of the modules in the form of push-buttons 13.

At the rear of each module the top surface is extended as shown at 14 to over-hang the rear face of the modules.  This over-hanging portion is intended to protect the input and output connections on the rear face of the modules.

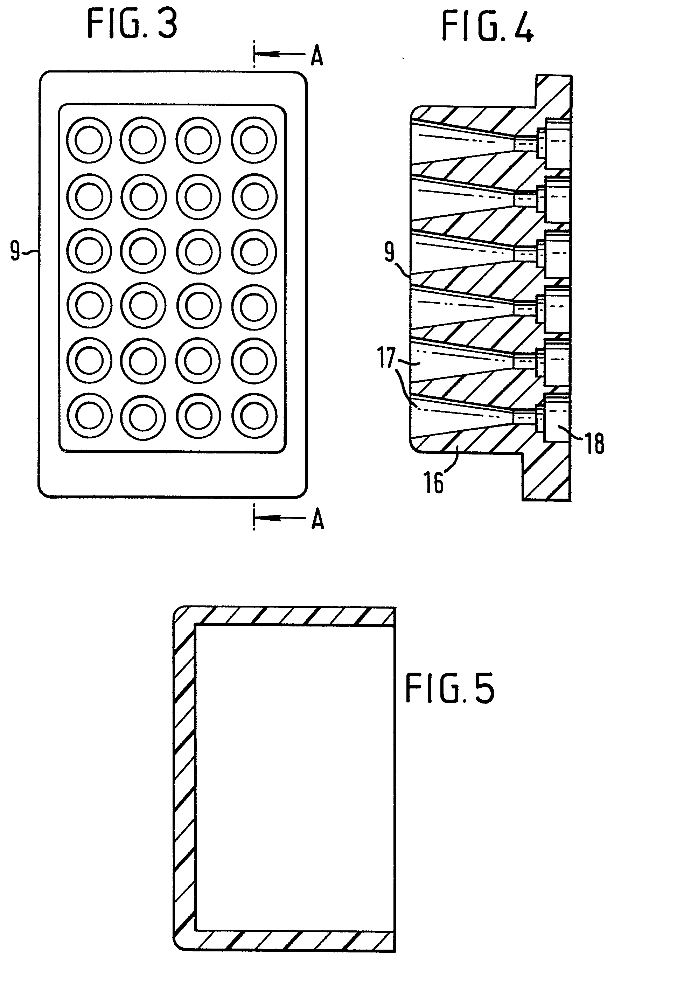

As can be seen from Figures 3 and 4 of the drawings the socket connector block 9 for receiving the corresponding pins 8 of the adjacent module is formed with a forward extension 16 which carries conical guide apertures 17 one of which is associated with each respective socket connector 18 so that the pins 8 are guided into position in the connector block. In this embodiment the pins and corresponding sockets are disposed in four rows each containing six sockets. Therefore the modules each have twenty four bus bars for interconnection.

Figure 5 shows a cross section of a cap arranged as a press fit over the pins 8 of the bus bar connectors to protect the pins against accidental damage.

CLAIMS

1. Electrical apparatus comprising a modular housing having a pair of opposite faces adapted to engage further similar modular housings, the modular housing having at least one bus bar extending between the opposite faces and arranged for connection to the corresponding bus bars of adjacent modular housings whereby the modular housings can be electrically interconnected.

2. Electrical apparatus comprising a modular housing having a pair of opposite faces adapted to engage the corresponding faces of further similar modular housings of electronic apparatus, the modular housing having at least one series of bus bars extending between the opposite faces of the housing and arranged for direct electrical connection to the corresponding bus bars of the adjacent modular housings.

3. Electrical apparatus according to claim 1 or claim 2, wherein one end of each bus bar is terminated by a pin connector and the other end of each bus bar is terminated by a socket connector.

4. Electrical apparatus according to any one of claims 1 to 3, comprising means for mechanically connecting the modular housings together independently of the bus bars.

5. Electrical apparatus according to claim 5, wherein the means for mechanically connecting the modular housings together comprises at least one tie rod extending between the said opposite faces of the housing, the tie rod being arranged for connection to the corresponding tie rod of adjacent modular housings.

6. Electrical apparatus according to any preceding claim, wherein the modular housing is generally rectangular in shape and comprises a front face which carries any necessary switches and visual indicators, a pair of side faces which form the said opposite faces and a rear face which carries any appropriate signal source inputs, power outputs and power outlets.

7. Electrical apparatus according to claim 6, wherein the top of the modular housing projects over the rear face to shield the inputs and outputs.

8. Electrical apparatus according to claim 6 or claim 7, comprising a flap hinged to the front face of the housing and arranged to cover at least one control on the front face.

9. Electrical apparatus according to claim 8, wherein the hinged flap covers substantially the whole of the front face and is arranged to actuate a switch which energises the electronics associated with the modular housing.

FIG.1

0076657

FIG. 2

FIG. 3

FIG. 4

FIG. 5